# EUROPEAN PATENT SPECIFICATION

(11) **EP 1 732 127 B1**
(45) Date of publication and mention of the grant of the patent: **14.12.2016**
(21) Application number: 06114626.2
(22) Date of filing: 29.05.2006
(51) Int. Cl.: H01L 23/31, H01L 25/03, H01L 25/10, H01L 21/98, H01L 21/60, H01L 23/498, H01L 23/485, H01L 25/065

(54) **Method for bonding and device manufactured according to such method**
Verfahren zum Bonden und mit dem Verfahren hergestellte Vorrichtung.
Procédé pour fixation et dispositif fabriqué par le procédé.

(30) Priority: 30.06.2005 US 171483; 08.06.2005 US 688908 P; 08.06.2005 EP 05447133
(43) Date of publication of application: 13.12.2006
(73) Proprietor: IMEC, 3001 Leuven (BE)
(72) Inventor: BEYNE, Eric, 3001 LEUVEN (BE)
(74) Representative: Pronovem

(56) References cited:
- EP-A1- 1 489 657
- EP-A2- 0 729 182
- EP-A2- 0 875 935
- JP-A- 2004 265 888
- US-A- 5 598 036
- US-A1- 2001 042 923
- US-A1- 2002 064 935
- US-A1- 2002 195 703
- US-A1- 2003 218 250
- US-B1- 6 229 158
- US-B1- 6 425 516
- US-B1- 6 555 917

## Description

### Field of the Invention

The present invention is related to the field of microelectronics, in particular to methods for bonding 2 elements, as for instance the bonding of 2 wafers, wafer and dies or dies and dies, particularly in the field of 3D-SIP (3-dimensional System in a Package) technologies.

### Background of the invention

In the field of 3D stacking of system-in-Package (SIP) devices, packages are used with solder ball connections (BGA; Ball Grid Array) and CSP (Chip Scale Package) -style connections. Also in other fields solder balls can be used to provide bonding between 2 elements.

In order to realize a dense 3D interconnection between such devices, small diameter solder-balls are required. However the diameter has to be larger than the height of the components, which are typically present on the individual SIP layers or elements. Solder balls are joined when they are in the liquid state. At making contact, they collapse and are joined in the form of a larger solder ball, which forms the final bonding structure between the two elements which are bonded together. The diameter of the final solder ball is larger than the diameter of the initial solder balls, and smaller than the sum of the diameters of the initial solder balls. In other words, the formation of the bonding structure requires an amount of space around the initial solder balls, on which no components or structures can be placed, otherwise these structures would be engulfed by the final solder ball after joining. Also, the final distance between bonded surfaces is determined by the diameter of the joint solder structure, and not by the sum of the diameters of the initial solder balls. This is why it is sometimes necessary to provide relatively large solder balls, when components of a large height are present on the elements to be bonded. This further decreases the space available on the surfaces to be bonded.

Document EP0875935 discloses a semiconductor device comprising solder bumps which are covered by a masking film, and surrounded at their base by a reinforcement film. The reinforcement film has a sloping cross section, and is aimed at reinforcing the bumps against shear forces caused by heat generated during operation of the semiconductor device.

Document EP729182 discloses the application of a resin layer between an external connecting electrode of a chip carrier, in the form of a solder ball, and a circuit wiring board. The aim of the resin layer is again related to a reduction of the risk of cracking due to a difference in thermal expansion coefficients.

Document US6425516 is related to a semiconductor device comprising a semiconductor substrate on which metal bumps having narrowed base portions are bonded, and coated on its top surface with a resin covering the base portions of the metal bumps.

### Aim of the invention

It is an aim of this invention to provide a method and corresponding devices for bonding 2 elements, as for instance the bonding of two SIP layers which can be part of a 3D-stack or multilayer stack, which alleviates or avoids the problems of the prior art.

### Summary of the invention

According to embodiments of the present invention, the solder balls of a first substrate are encapsulated in a polymer resin (e.g. glob-top epoxy or packaging plastic molding compound) and only exposed at the top surface. The solder ball of the second substrate can then be mounted on the first ball, without the risk of collapse of the solder column or shorting between neighbouring solder connections. In particular, the invention is related to a method wherein a first element (eg a substrate) is provided with one or more solder balls on its main surface, and a second element (eg a chip or die) is equally provided with one or more solder balls on its main surface, and wherein said elements are bonded via contacting two solder balls of the respective elements, to form a solder structure, through a reflow step of said solder balls.

The method of the invention is defined in claim 1 with preferred embodiments defined in the dependent claims and comprises a step of providing, prior to bonding, a layer of non-conductive material on the main surface of at least one of said elements. This layer of non-conductive material (eg an epoxy resin) is parallel to the main surface to which it is applied, and its height is preferably at least 50% of the height of the embedded solder ball. According to further preferred embodiments, the height of the layer is at least 60%, or at least 70%, or at least 80%, or at least 90% of the solder ball height, but lower than 100%: according to the preferred embodiment, the layer of non-conductive material is applied so that it does not cover the solder balls completely. According to another embodiment, the layer of non-conductive material is applied on a main surface, to cover the solder balls on said surface completely, after which a back-grinding step is applied, to reduce the thickness of the polymer layer and expose the top surface of the solder balls (a segment of the top of the solder ball will be removed, leaving an approximately flat, typically circular solder area). Also in the latter embodiment, after the back-grinding step, the non-conductive layer does not cover the upper part of the solder ball. Also in the embodiment involving a back-grinding step, the height of the layer of non-conductive material is preferably at least 50% and less than 100% of the height of the *original* solder ball.

According to one embodiment, both the first and second solder ball are embedded in a layer of non-conductive material, and the contact is made by applying a third solder volume, as for instance but not only, a third solder ball, or a third and a fourth solder ball, between the first and second solder balls or solder volumes. This third solder volume may be applied to only one or both layers comprising at least partially embedded solder balls. A part of the solder volume can thus be applied on one layer comprising at least partially embedded solder balls, while the remaining solder volume can be applied on the other layer comprising at least partially embedded solder balls. Different methods may be used to apply the third solder volume, such as e.g. the placement of preform solder balls, screen printing or solder jetting. The volume of the third solder volume may be optimised to achieve an appropriate solder thickness.

As a result of the embedding layer around one or both the solder balls which are to be joined, the collapse of these solder balls into a large joined solder ball is avoided. In stead, the final joint structure is a stack of the two original solder balls, with a lateral width which is approximately equal to the diameter of the original solder balls, and a height approximately equal to the sum of the diameters of the original solder balls. This makes it possible to use more of the surface of the elements to be bonded, and to increase the distance between the bonded surfaces, after joining, so that larger (higher) components or structures may be present on the surfaces. When a third solder ball is applied, the resulting solder structure can be a stack of three balls of approximately equal diameter. It can also be a stack of an upper solder ball, a lower solder ball, and a middle solder volume as for instance a third or middle solder ball. The middle or third solder ball does not need to have the same dimensions as the first and the second solder balls. The dimensions of the first and second solder balls do not necessarily have to be the same.

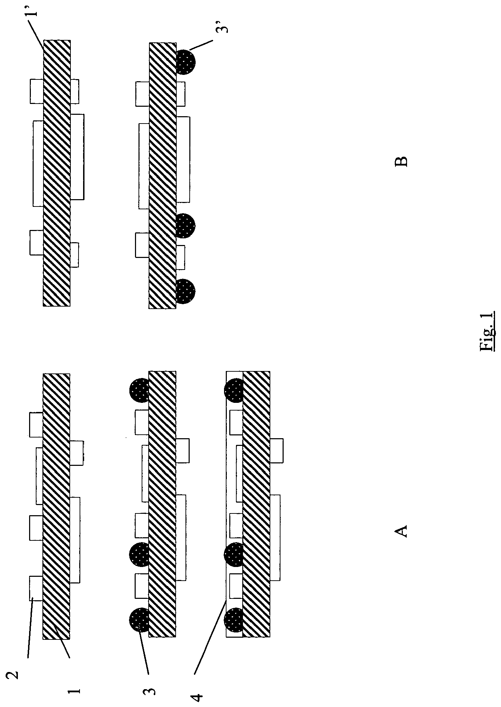

For the purpose of the present invention, SiP packages should be understood as packages comprising an interconnect substrate 1 and devices 2 mounted on the surface of said substrate (see Fig. 1). The thus packaged circuit can realize a system or subsystem functionality. Components can be mounted on both sides of the CSP substrates. These components can be wire-bonded or flip-chip mounted IC's, standard SMT (Standard Mount Technology) passives or other components such as clock reference crystals, but also other devices. These components can typically be characterised by having a height above the substrate different from zero and up to several hundreds of micrometer.

The solder balls can have a diameter between 100 microns and 1 mm. They can for instance have a diameter of 200, 300, 400, 500, 600, 700, 800, 900 microns. Also smaller or larger solder balls are possible.

According to an embodiment of the invention, the layer of non-conductive material is present on an element which comprises components or structures on its main surface. In that case, the non-conductive layer may cover said components or structures completely, i.e. the thickness of the non-conductive material layer is larger than the maximum thickness of the components or structures.

According to the invention, at least one of the non-conductive layers is provided with an exclusion area, which is an area where no non-conductive material is present or where the thickness of the non-conductive material is lower than on the remainder of the main surface on which said non-conductive material is applied. One of the elements comprises on its main surface a component or structure which is higher than the solder balls on said surface, and which is positioned facing an exclusion area on the opposite element when the elements are bonded together. In this way, due to the exclusion area and the fact that the component in question is less high than the solder structure, the component does not touch the opposing element when said elements are bonded together.
According to an embodiment, said exclusion area further comprises a confinement structure, providing an enclosure to the exclusion area.
The method may comprise a step of applying an underfill/overmould material, to fill the gaps between the elements, after the bonding step.

The method of the invention may be applied an integer number of times, to obtain a stack of more than two elements, starting by bonding a third element to a main surface of the device obtained by the steps described above. Further elements may be bonded to the device obtained from that further step and so on. In the case of a device comprising more than two elements, bonded together according to the method of the invention, the underfill/overmould step may be performed after every bonding step, or one underfill/overmould step may be performed for the whole package, after the conclusion of all the consecutive bonding steps. Also according to an embodiment of the invention, a reflow step may be performed at each bonding process between two elements, or the same reflow step can be applied for bonding all elements in a stack. Another possibility is to apply the method of the invention to bond together M elements with M>2, by N reflow steps, with N<M-1.

The invention is equally related to a device produced according to the method of the invention. Said device is defined in claim 19 with preferred embodiments defined in the dependent claims and is characterized in that it comprises a first and second element, bonded together by one or more bonding structures, each structure having been obtained by bonding a first solder ball present on a main surface of the first element, to a solder ball present on a main surface of the second element, and thereby essentially consisting of a stack of two solder balls. At least one of the elements of said device is further provided with a layer of non-conductive material, on the main surface of said element, and embedding the solder ball(s) present on said main surface. According to the invention, said layer is parallel to the main surface to which it is applied. At least one of the elements which are part of said device may comprise one or more components or structures on its main surface, and extending outward from said surface. In one embodiment, both of the solder balls are embedded in a layer of non-conductive material, and the bonding structure comprises a solder structure which is essentially a stack of a lower solder ball, an upper solder ball and a middle solder volume as for instance a third solder ball, which are forming a single structure.

According to the invention, in a device of the invention at least one of the non-conductive layers is provided with an exclusion area, which is an area where no non-conductive material is present or where the thickness of the non-conductive material is lower than on the remainder of the main surface on which said non-conductive material is applied. One of the elements comprises on its main surface a component or structure which is higher than the solder balls on said surface, and which is positioned facing an exclusion area on the opposite element when the elements are bonded together. In this way, due to the exclusion area and the fact that the component in question is less high than the solder structure, the component does not touch the opposing element when said elements are bonded together.

According to an embodiment of the device, said exclusion area further comprises a confinement structure, providing an enclosure to the exclusion area. In a device according to the invention, said bonding structure may further comprise a layer of underfill/overmold material in between said main surfaces of said elements. Said layer of underfill/overmould material may be located between a main surface of one element and an embedding layer or between 2 embedding layers.

### Description of the figures

The figures 1-9 illustrate aspects of methods and devices according to embodiments of the present invention. In Fig. 1 to Fig. 4 aspects of embodiments wherein 2 elements are bonded are illustrated.
Fig. 1: preparation of the SiP substrate (case of 2 substrates)
Fig. 2: principle of the SiP substrate stacking (case of 2 substrates)
Fig. 3a: principle of the SiP substrate stacking : using wafer or substrate as a basis. (case of 2 substrates)
Fig. 3b: principle of the SiP substrate stacking : using wafer or substrate as a basis. (case of 2 substrates)
Fig. 4: principle of the SiP substrate stacking : including bottom-side molding (case of 2 substrates)
Fig. 5 and Fig. 6: embodiments wherein 3 or more elements or substrates are bonded :

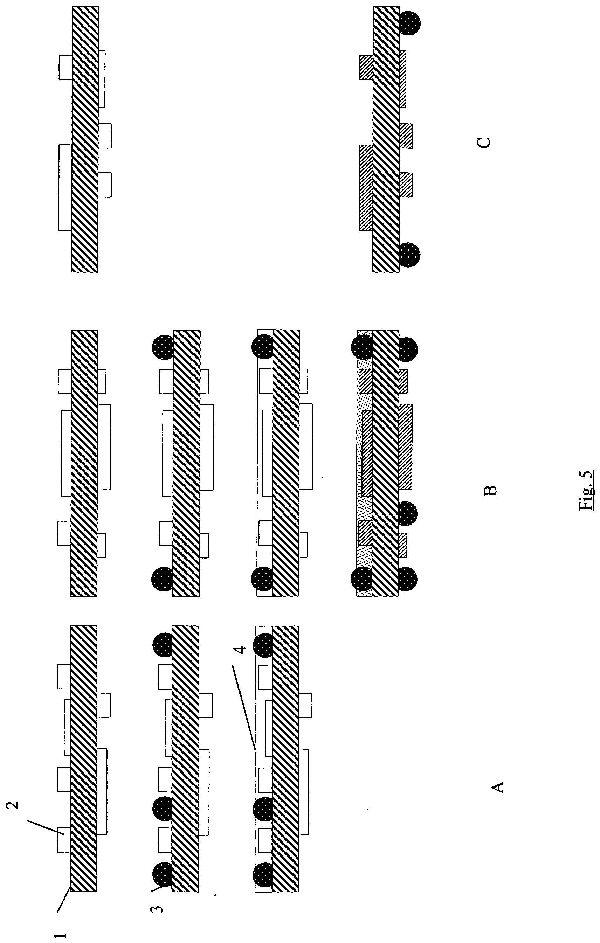

Fig. 5: preparation of the SiP substrate (case of 3 or more substrates)

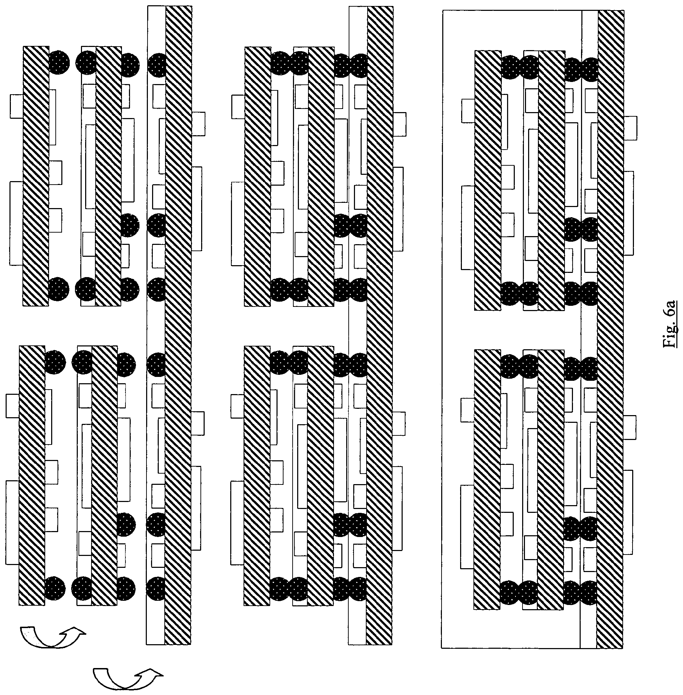

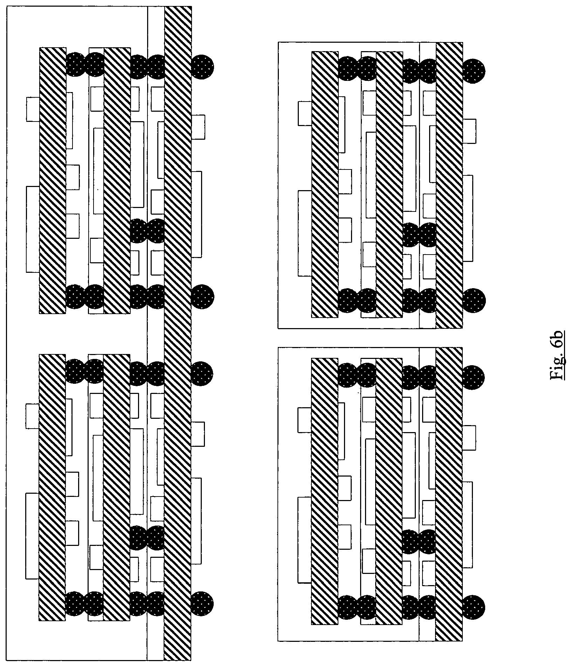

Fig. 6a and 6b: principle of the SiP substrate stacking : using wafer or substrate as a basis (case of 3 or more substrates)

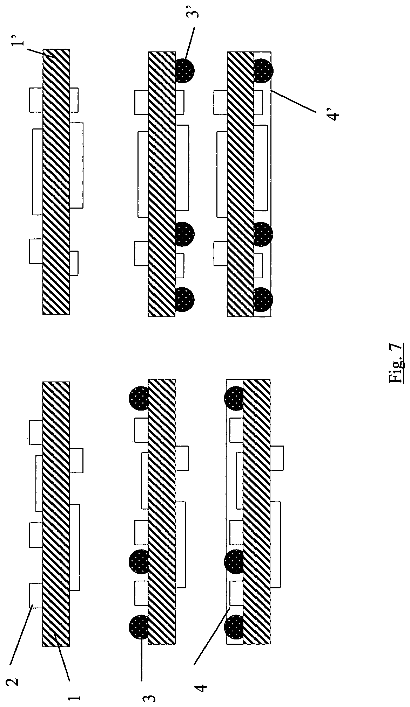

In Fig. 7 to Fig. 9, aspects of further embodiments according to the present invention are illustrated, which are similar to the embodiments illustrated in Fig. 1 to Fig. 6, but wherein both solder balls which are to be joined are both partially embedded in a non-conductive material as described in detail in the description.
Fig. 7: alternative preparation of the SiP substrate (case of 2 substrates)

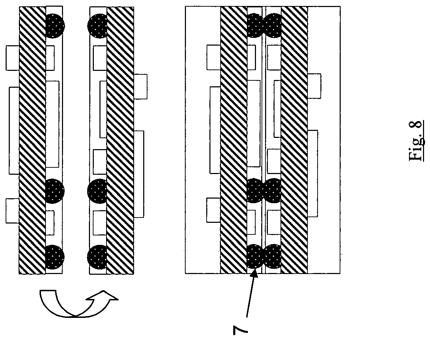

Fig. 8: principle of the SiP substrate stacking (alternative case of 2 substrates)

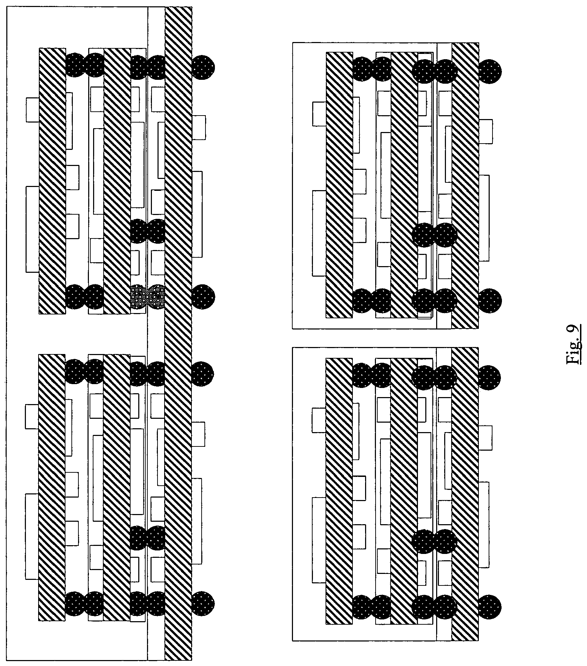

Fig. 9: principle of the SiP substrate stacking : using wafer or substrate-level Base wafer (case of 3 or more substrates, alternative)

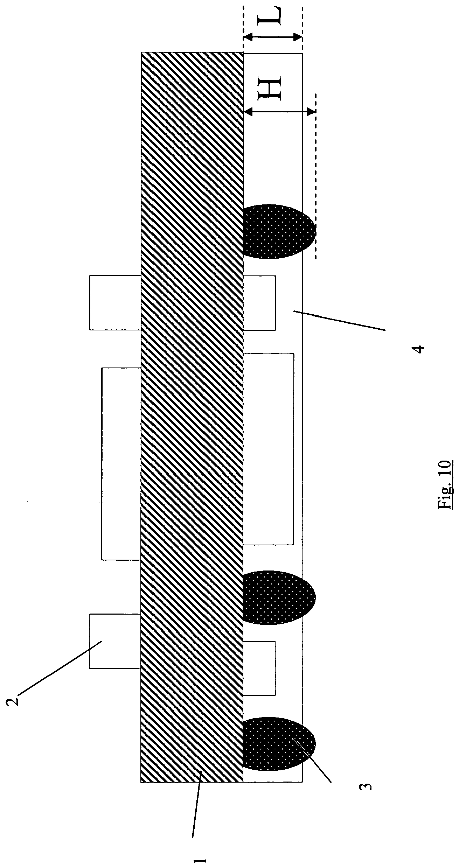

In Fig. 10 a generic representation is given of a solder ball or structure on a first main surface of an element and the height parameter is indicated.

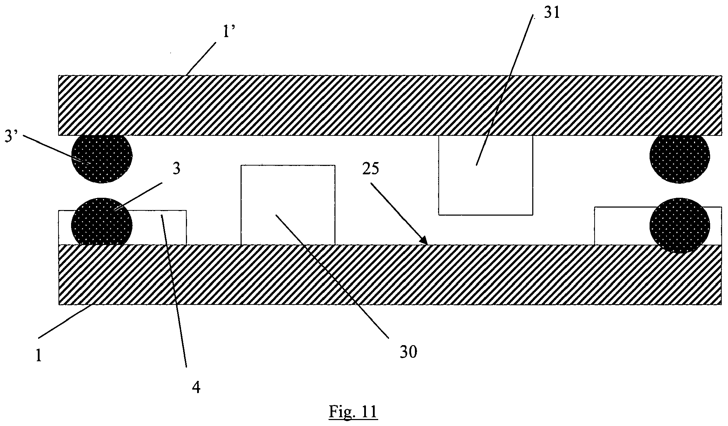

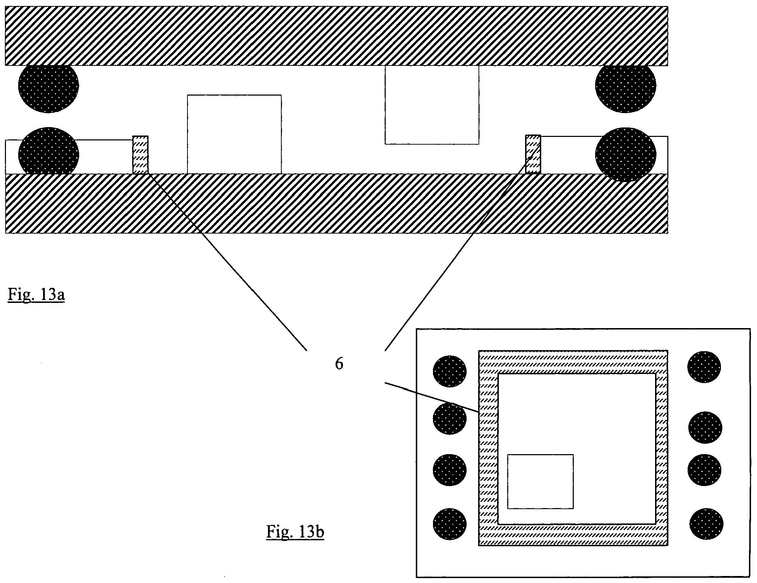

Fig. 11 to 14 illustrate aspects of the present invention. Fig. 13b is a top view of Fig. 13a.

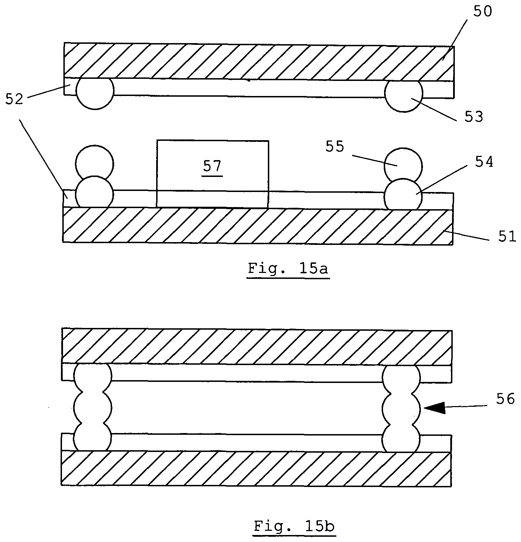

Fig. 15 illustrates aspects of an embodiment of the method and device of the invention, involving a solder structure with three solder balls.

### Detailed description of the invention

The present invention will be described with respect to particular embodiments and with reference to certain drawings. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes. It is to be understood that the terms so used are interchangeable under appropriate circumstances and that the embodiments of the invention described herein are capable of operation in other orientations than described or illustrated herein. The same reference signs in different figures refer to similar elements.

A method for bonding is disclosed comprising the steps of
- producing on a first main surface of a first element a first solder ball,
- producing on a first main surface of a second element a second solder ball,
- providing contact between the first solder ball and the second solder ball,
- bonding the first element and the second element by applying a reflow step whereby the solder balls
melt and form a joined solder ball structure wherein, prior to the bonding step, the first solder ball is laterally embedded in a non-conductive material (therefore called embedding layer), such that the upper part of the first solder ball is not covered by the non-conductive material.

A step of applying a underfill/overmould material after the bonding step between the first main surface of the second element and the first main surface of the first element can be applied.

Also the second solder ball can be laterally embedded in a non-conductive material, such that the upper part of the second solder ball is not covered by the non-conductive material. This non-conductive material is preferably laterally embedding (therefore called embedding layer) the second solder ball up to an embedding level parallel to the first main surface and which does not extend above the second solder ball.

The first main surface of the first element and/or the first main surface of the second element may comprise components or structures, whereby the first and the second solder balls are such that the height of the components and/or structures is smaller then the height of the first solder ball and/or the second solder ball respectively. In such a case the height of the embedding layer(s) should preferably be higher than the height of the components (and of course lower then the respective solder ball height).

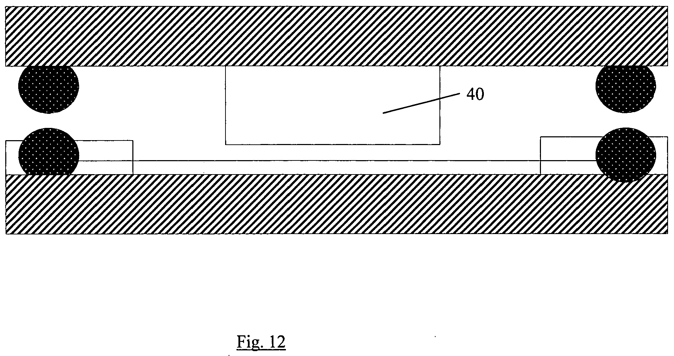

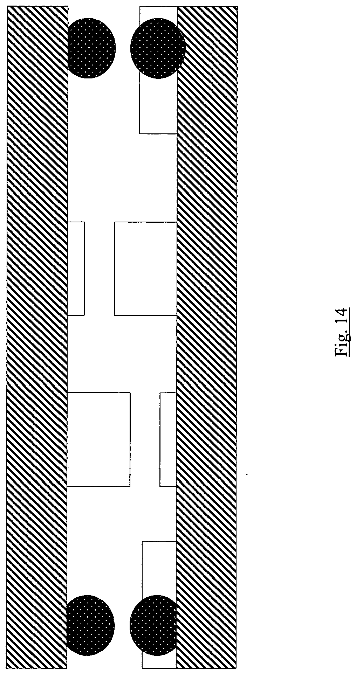

The first main surface of the first element and/or the first main surface of the second element comprise components or structures which have a topology that extends outwards from the respective main surfaces, and whereby the first and the second solder balls are such that the height of at least one of the components and/or structures on the first main surface of the first element and/or the first main surface of the second element is smaller then the height of the joined solder ball structure, but higher than the solder balls on the corresponding main surface. This can be achieved by providing preformed embedding layers which for instance include exclusion areas (see eg Fig. 11, Fig 13a, b and Fig 14), or recesses (see eg Fig. 12), ie areas in which no or only a thinner layer of non conductive material is present respectively. Such embedding layers which comprise exclusion areas or recesses can be produced by transfer moulding or injection moulding techniques. Also a glob-top technique whereby a liquid encapsulant is applied can be used. The presence of additional confinement structures 6 (eg see Fig. 13), which provide enclosures corresponding to exclusion areas, may be necessary, such that no non-conductive solder ball embedding material can enter the exclusion area. Such confinement structures are not always necessary; moulding techniques can also be used which provide exclusion areas. When exclusion areas are provided on both main surfaces (or similar whereby an embedding layer is only present on one main surface only and comprises an exclusion area), which moreover overlap, and in which on both main surfaces in the respective exclusion area, components are provided, special care should further be taken in the positioning of the components on the first main surfaces, such that components present on the first main surface of a first element are not blocked by components mounted on the first main surface of the second element when both elements are to be bound. This can be achieved by combining lower height components on a first main surface of a first element, with higher height components on a main surface of a second element (eg see Fig. 14), or by misaligning the components on the first and second main surfaces on the first and second elements respectively (see Fig. 11). The combined height of the two components should though be smaller then the joined solder ball structure. It should further be understood that lower and higher components in an exclusion area on a first main surface of a first element can be combined with higher and lower components respectively in an exclusion area on a second main surface of a second element. This shown in Fig. 14.

A step of applying an underfill / overmold operation, which fills up the remaining gaps between the elements can be applied.

The methods can of course be used repetitively for stacking more then 2 or 3 elements.

A method for producing stacked structures is disclosed, wherein one of the earlier described methods is applied an integer number of times, by repetitively bonding a main surface of an element to a main surface of a further element.

When more than 2 elements are stacked, the step of applying an underfill/overmold operation can advantageously be applied only once for the whole stacked structure, although this is not strictly necessary.

The elements referred to can be any element known to be usable to a person of ordinary skill in the art, but can for instance be substrates, wafers, chips or dies.

Devices are disclosed, corresponding to the methods described previously, comprising at least 2 elements, the elements being bonded by a bonding structure 7 located between a first main surface of a first element and a first main surface of a second element, wherein the bonding structure comprises a solder structure which is essentially a stack of a lower and an upper solder ball, which are forming a single structure.

The solder structure 7 is essentially 8-shaped; which means that any cross-section of the structure along the lontitudinal axis provides a "8" form, the form of the number "eight". Each of the 2 loops of this 8-shape then corresponds to a solder ball. The "8" form can be such that the upper loop is larger then the lower loop, or such that the lower loop is larger then the upper loop; ie the first and second solder balls do not necessarily need to be of the same dimensions.

The lower or/and the upper solder ball(s) is/are laterally embedded in a non conductive material up to an embedding level which is lower then the height of the top surface of the respective solder balls.

The first main surface of at least one of the elements may comprise at least one component which extends outwards from the first main surface of the corresponding element, and the respective embedding levels are further such that the component(s) are completely covered by the non conductive material.

The bonding structure can further comprise a layer of underfill / overmold material in between the first main surfaces of the elements.

A device is also disclosed, wherein the layer of underfill/overmould material is located between a first main surface of one element and an embedding layer on a first main surface of a second element or between the 2 embedding layers of the 2 first main surfaces of the 2 elements respectively.

### Description of preferred embodiments of the invention

In Fig. 1 the preparation SiP devices for 3D stacking is illustrated, according to embodiments of the present invention. Sequence A is directed to a bottom substrate 1 and sequence B to a top substrate 1'. Components 2 are mounted on the elements 1, 1', eg substrates or wafers. The component can be any type of surface mount component known to a person of ordinary skill in the art. Such component typically extends outwards of a main surface of the element e.g. substrate. In Fig. 10 the parameters "H"; height and "L"; level are illustrated generically.

Next, solder balls 3, 3' are attached to the top of the bottom substrate and the bottom of the top substrate, using standard BGA and CSP solder ball mounting techniques. Preferably, pre-form solder balls are used, placed on the substrate by a collective technique (e.g. stencil printing) and attached to the substrates by reflow soldering.

The attachment may actually be performed simultaneously with the deposition of some of the surface mount components 2 in the prior step. The solder balls can be individually picked and placed with a fine pitch SMT (surface mount technology) placement machine.

In a next step, the solder balls and surface mounted components on the bottom wafer are encapsulated with a polymer layer 4. The solder balls should however not be completely covered by this layer.

Possible methods are the dispensing of a liquid epoxy 'glob-top' or 'under-fill' type compound that automatically levels and fills all gaps between and below components. Also transfer molding of plastic encapsulation material can be used.

In case the solder balls are covered by a layer thicker than the solder balls, a back grinding step can be used to reduce the thickness of the polymer layer and expose the top surface of the solder balls (a segment of the top of the solder ball will be removed, leaving a approximately flat, typically circular solder area).

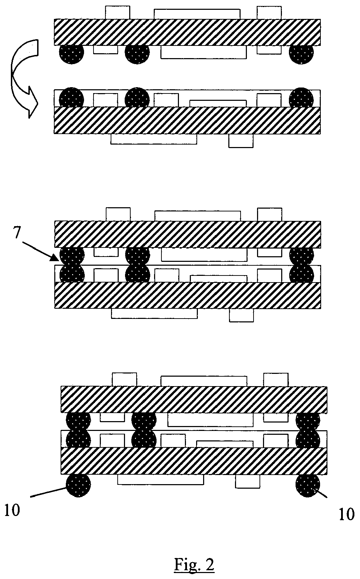

In Fig. 2 the principle of stacking of 2 SIP devices is illustrated. The top substrate SiP is mounted to the base substrate and attached using solder reflow. The distance between the substrates is maintained as the bottom solder ball is not able to collapse during soldering. From a certain viewpoint, the bottom solder balls act as regular contact pads for the top SiP solder balls. Due to the non-collapse of the solder ball, a solder structure 7 is formed between the joined substrates, having the shape of an '8'.

After reflow, solder balls 10 can be applied to the second main surface of the bottom substrate to finalize the 3D-SiP assembly. The solder balls 10 on the second main surface of the bottom substrate can be already present before the reflow step.

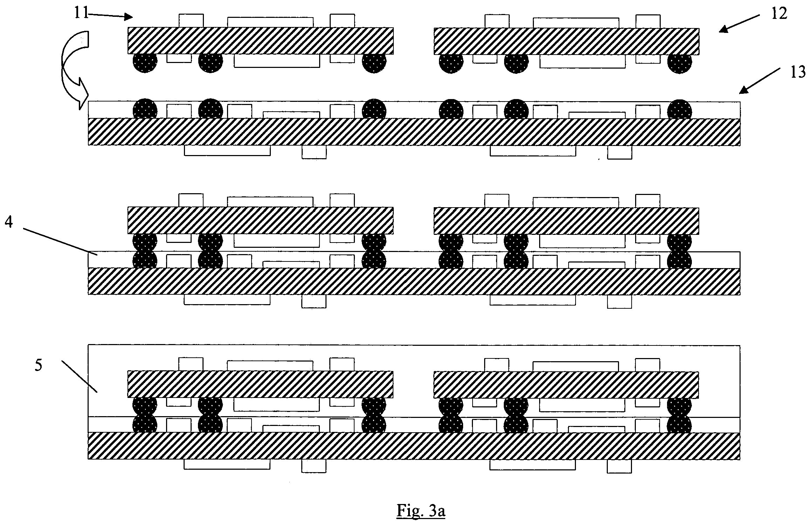

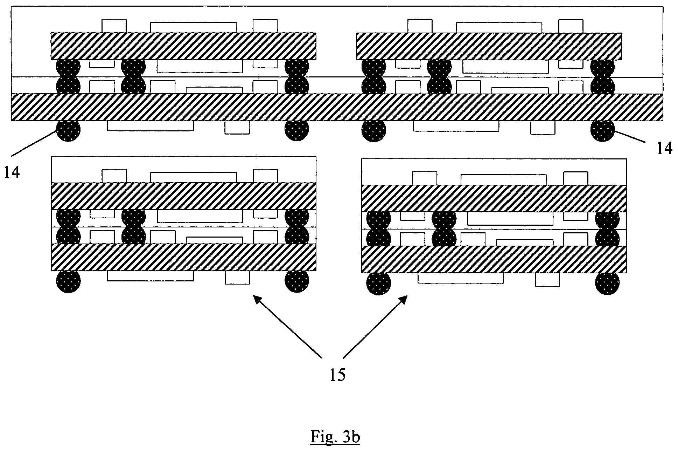

This step of Fig. 2 may be performed with large substrates with arrays of SIP devices or with singulated and tested SiP substrates, or with singulated and tested SiP devices mounted on tested SiP substrates as shown in Fig. 3a and Fig. 3b. Such testing performed on the devices and substrates can be testing the functioning, the performance, the reliability etc of the devices and substrates respectively.

In Fig. 3, a method is illustrated, wherein 2 tested SIP devices 11,12 are stacked on an SIP substrate 13.

This flow is similar to the one of fig. 2, but here tested known-good SIP are placed on tested known-good SIP sides of the bottom wafer (with 'known-good' is meant "tested with a positive result", and thus properly usable). Defective sites on the bottom substrate can be and are preferably left empty.

In addition, after mounting the devices, an underfill/overmold operation can be performed, encapsulating all structures by a layer 5, see figure 3a and Fig. 6. Standard transfer molding is a preferred option for this process, but also possible is the use of liquid epoxy encapsulants as used for 'glob-top' or 'under-fill' applications, as well as suitable options known to a person of ordinary skill.

Solder balls 14 can be applied to the second main surface of the bottom substrate after this molding step (figure 3b), or before. After this step, dicing the substrate to obtain fully encapsulated 3D-SIP devices 15 can be performed.

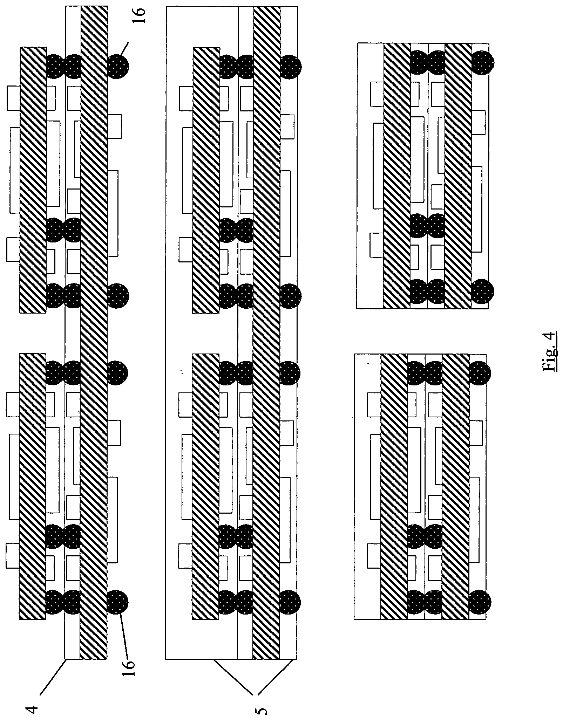

In fig. 4 further methods are illustrated. Here, solder balls 16 are provided to the second main surface of the bottom substrate before the moulding step. Moulding is then performed on both sides of the substrate (see layers 5 in figure 4), however, leaving the tips of the bottom solder balls partially free. This module can be used as land-grid array type package, or a second solder ball can be applied on the bottom for improved thermo-mechanical reliability after assembly to a motherboard.

In Fig. 5 and 6 other methods are depicted. The preparation and stacking of SiP devices for 3D stacking in the case of 3 or more samples is shown.

These methods are similar to those of fig. 1 to Fig. 4, regarding the preparation of the bottom (sequence A) and top (sequence C) substrates. However, the substrate or substrates in the middle (sequence B) are receiving solder balls on both sides.

In certain methods a reflow step can be applied at each bonding process between 2 elements. In other embodiments the same solder reflow step can be applied for bonding all elements in a stack. In certain methods, N reflow steps are performed for bonding M elements, with N < M-1, for M > 2.

In Fig. 7 to Fig. 9, further methods are illustrated, which are similar to the methods of Fig. 1 to Fig. 6, but wherein both solder balls 3,3' respectively attached to a first main surface of a first element 1 and a first main surface of a second element 1' are both embedded laterally by respective non-conductive layers 4, 4' up to respectively level L and L', which are below the respective levels H and H' of the top surface of the respective solder balls. (see Fig. 10 where a generic representation is given of a solder ball or structure on a first main surface of an element and the height parameters L and H are indicated).

Such structures can be used in the bonding of 2, 3, or more SIP levels. For each couple of to-be-joined solder balls, at least one, but also both solder balls can be embedded laterally by a non-conductive material. This choice depends on the requirements, typically spacing between 2 SIP level - requirements, of a specific structure.

Figures 11 to 14 illustrate embedding layers of non-conductive material according to the invention, and provided with exclusion areas. Figure 11 shows the assembly of a first substrate 1 and a second substrate 1', wherein an embedding layer 4 is present on the first substrate. The layer 4 is embedding the solder balls 3 on the first substrate up to a level below the height of the embedded solder balls. The second substrate carries solder balls 3' but no embedding layer. The embedding layer 4 is provided with an exclusion area 25, which is an open space on the first substrate's main surface, on which no non-conductive material is present. The first and second substrate have components 30 and 31 on their surface respectively, which are higher than the solder balls on the respective surfaces on which they are present. The components are positioned thus that they do not touch each other during assembly of the device. In particular, component 31 on the second substrate is facing the exclusion area on the first substrate during bonding, so that bonding can take place without the component 31 touching the lower substrate.

Figure 12 shows an exclusion area which is provided for the same purpose, i.e. to avoid contact between a component 40 and the lower substrate. In this case, however, the exclusion area is not free of non-conductive material, but provided with a layer of such material, which is lower in thickness than on the remainder of the surface.

Figure 13 shows the possibility of providing a reinforcement structure 6 along the border of the exclusion area, to reinforce the non-conductive material around said area, and retain said material outside the exclusion area. Figure 14 shows another embodiment, wherein both substrates carry components, arranged on said exclusion area.

Figure 15 shows a method, wherein a third solder volume, here a solder ball is applied between the two solder balls applied directly to the main surfaces. In this method, a first solder ball 54 is produced on the main surface of the first element (lower substrate) 51, a second solder ball 53 is produced on the main surface of the second element (upper substrate) 50, and both solder balls are embedded in a layer 52 of non-conductive material which is parallel to the respective main surfaces. A third solder ball 55 is then produced on the solder ball 54 on the lower substrate, and the upper substrate is bonded to the lower substrate, so that the contact between the solder balls 53, 54 arranged on the respective surfaces, is made through the third solder ball 55. The final bonding structure is a stack 56 of three solder balls, of approximately equal diameter. The production of the third solder ball is done by the same methods as are used for the other two solder balls. The bonding step and possibly subsequent underfill application steps are performed according to the same methods as described above for the two-solder ball methods. This embodiment equally allows several elements to be bonded together in a package, by repeated application of the three-solder ball method, or by use of the three solder ball method in combination with the above-described two-solder ball method. This 3-ball method allows larger distances between the bonded substrates, which may be necessary when high components (e.g. component 57 in fig. 15) are present on one or both of the substrates. An embodiment of the invention is equally related to a device comprising a bonding structure comprising a stack 56 of three solder balls, the upper and lower solder balls being embedded by a layer of non-conductive material.

According to the above described methods and devices, the material of the two bonded solder balls in figures 1-14 is the same material. Equally, in figure 15, and in methods and devices wherein more than one additional solder volume is applied between the first and second solder balls, the material of all the solder volumes used, is the same material.

## Claims

1. A method for bonding elements (1,1') comprising the steps of
- producing on a main surface of a first element a first solder ball (3),
- producing on a main surface of a second element a second solder ball (3'),
- providing contact between said first solder ball (3) and said second solder ball (3'),
- bonding said first element (1) and said second element (1') by applying a reflow step whereby said solder balls melt and form a joined solder ball structure (7)
wherein :
- prior to the bonding step, the first and/or second solder ball (3) is laterally embedded in a layer (4,4') of non-conductive material, by providing said layer of non-conductive material on the main surface of the first and/or the second element, such that the upper part of said first and/or second solder ball is not covered by said non-conductive material, and
- said layer (4,4') of non-conductive material is laterally embedding said first and/or second solder ball (3) up to a level parallel to the main surface onto which the non-conductive layer (4,4') is provided,
**characterized in that** :
on one of said main surfaces, the layer (4,4') of non-conductive material is provided with an exclusion area (25), being an area wherein no non-conductive material is present in said area, or wherein in said area a non-conductive layer is present with a lower thickness than on the remainder of the main surface on which said non-conductive layer (4,4') is applied, and on the other main surface, at least one component (30,31,40) is present whereof the height is larger than the height of the solder ball on said other surface, and wherein said component faces said exclusion area (25) when the elements are bonded together, so that due to the exclusion area, said component does not touch the opposite element.

2. Method according to claim 1, wherein the height of said parallel layer (4,4') on the main surface of said first or second element, is at least 50% of the height of the respective solder balls on said main surfaces.

3. Method according to claim 1, wherein the height of said parallel layer (4,4') on the main surface of said first or second element, is at least 60% of the height of the respective solder balls on said main surfaces.

4. Method according to claim 1, wherein the height of said parallel layer (4,4') on the main surface of said first or second element, is at least 70% of the height of the respective solder balls on said main surfaces.

5. Method according to claim 1, wherein the height of said parallel layer (4,4') on the main surface of said first or second element, is at least 80% of the height of the respective solder balls on said main surfaces.

6. Method according to claim 1, wherein the height of said parallel layer (4,4') on the main surface of said first or second element, is at least 90% of the height of the respective solder balls on said main surfaces.

7. Method according to any one of claims 1 to 6, wherein said main surface of the first and/or the second element (1,1') comprises one or more components or structures (2) extending outwards from said respective main surfaces, wherein the height of said component(s) or structure(s) (2) present on said main surface is smaller than the height of the solder ball present on said main surface on which the component (s) or structure(s) are present.

8. The method according to claim 7, wherein a layer of non-conductive material (4,4') is applied on one of said main surfaces on which one or more components or structures (2) are present.

9. The method according to claim 8, wherein the height of said layer (4,4') is larger than the maximum height of said components or structures (2).

10. The method according to claim 1, wherein the main surface comprising said exclusion area (25) further comprises a confinement structure (6), providing an enclosure to the exclusion area.

11. Method according to any one of claims 1 to 10, further comprising a step of applying an underfill/overmold operation, which fills up the remaining gaps between said elements.

12. Method for producing stacked structures, wherein the method according to any one of claims 1 to 11 is applied an integer number of times, by repetitively bonding a main surface of an element, bonded before by a method according to any one of claims 1 to 11, to a main surface of a further element.

13. Method according to claim 12, wherein a step of applying an underfill/overmold operation is applied only once for the whole stacked structure.

14. Method according to claim 12, wherein the same solder reflow step is applied for bonding all elements in a stacked structure.

15. Method according to any one of claims 1 to 14, wherein said elements are substrates, chips or dies.

16. Method according to any one of the preceding claims, wherein the solder balls (53,54) on both of said main surfaces are laterally embedded in a layer (52) of non-conductive material, producing first and second embedded solder balls, and further comprising the step of applying a third solder volume (55) on one of said embedded first or second solder balls, prior to the bonding step.

17. Method according to claim 16, wherein said third solder volume is applied in the form of a third solder ball (55).

18. Method according to any one of the preceding claims, wherein said first and second solder ball (3,3'), or said first and second solder ball and the third solder volume (53,54,55) are made of the same material.

19. A device comprising at least 2 elements (1,1'), said elements being bonded by a bonding structure located between a main surface of a first element (1) and a main surface of a second element (1'), wherein said bonding structure comprises a solder structure (7) which is essentially a stack of a lower and an upper solder ball, which are forming a single structure, wherein
- said lower or/and said upper solder ball(s) is/are laterally embedded in a layer (4,4') of non conductive material and
**characterized in that** :
said layer (4,4') of non-conductive material is parallel to the respective main surface to which it is applied, and on one of said main surfaces, the layer (4,4') of non-conductive material is provided with an exclusion area (25), being an area wherein no non-conductive material is present in said area, or wherein in said area a non-conductive layer is present with a lower thickness than on the remainder of the main surface on which said non-conductive layer (4,4') is applied, and on the other main surface, at least one component (30,31) is present whereof the height is larger than the height of the solder ball on said other surface, and wherein said component faces said exclusion area when the elements are bonded together, so that due to the exclusion area, said component does not touch the opposite element.

20. A device according to claim 19, wherein the height of said layer (4,4') of non-conductive material is at least 50% of the height of the solder ball which is embedded by said layer.

21. The device according to claim 19, wherein the main surface comprising said exclusion area (25) further comprises a confinement structure (6), providing an enclosure to the exclusion area.

22. The device according to any one of claims 19 to 21, wherein said bonding structure further comprises a layer (5) of underfill/overmold material in between said main surfaces of said elements.

23. The device according to claim 22, wherein said layer (5) of underfill/overmould material is located between a main surface of one element and an embedding layer or between 2 embedding layers.

## Patentansprüche

1. Verfahren zum Bonden von Elementen (1, 1'), das die Schritte umfasst:
- Herstellen einer ersten Lötkugel (3) auf einer Hauptoberfläche eines ersten Elements,
- Herstellen einer zweiten Lötkugel (3') auf einer Hauptoberfläche eines zweiten Elements,
- Bereitstellen eines Kontakts zwischen der ersten Lötkugel (3) und der zweiten Lötkugel (3'),
- Bonden des ersten Elements (1) und des zweiten Elements (1') durch Durchführen eines Reflowschritts, wodurch die Lötkugeln schmelzen und eine verbundene Lötkugelstruktur (7) bilden
wobei:
- die erste und/oder zweite Lötkugel (3) vor dem Schritt des Bondens lateral in eine Schicht (4, 4') aus nicht-leitfähigem Material eingebettet wird, indem die Schicht aus nicht-leitfähigen Material auf der Hauptoberfläche des ersten und/oder des zweiten Elements bereitgestellt wird, so dass der obere Teil der ersten und/oder der zweiten Lötkugel nicht von dem nicht-leitfähigen Material bedeckt ist, und
- die Schicht (4, 4') aus nicht-leitfähigem Material die erste und/oder die zweite Lötkugel (3) bis zu einer Ebene parallel zur Hauptoberfläche einbettet, auf der das nicht-leitfähige Schicht (4, 4') bereitgestellt ist,
**dadurch gekennzeichnet, dass**:
auf einer der Hauptoberflächen, die Schicht (4, 4') aus nicht-leitfähigem Material mit einem Ausschlussbereich (25) versehen ist, bei des es sich um einen Bereich handelt, wobei kein nicht-leitfähiges Material in dem Bereich vorhanden ist, oder wobei in dem Bereich eine nicht-leitfähige Schicht mit einer geringeren Dicke als auf dem Rest der Hauptoberfläche vorhanden ist auf der die nicht-leitfähige Schicht (4, 4') aufgetragen ist, und auf der anderen Hauptoberfläche zumindest eine Komponente (30, 31, 40) vorhanden ist, deren Höhe größer als die Höhe der Lötkugel auf der anderen Oberfläche ist, und wobei die Komponente dem Ausschlussbereich (25) zugewandt ist, wenn die Elemente aneinander gebondet sind, so dass die Komponente das gegenüberliegende Element aufgrund des Ausschlussbereichs nicht berührt.

2. Verfahren nach Anspruch 1, wobei die Höhe der parallelen Schicht (4, 4') auf der Hauptoberfläche des ersten oder des zweiten Elements zumindest 50 % der Höhe der jeweiligen Lötkugeln auf den Hauptoberflächen ist.

3. Verfahren nach Anspruch 1, wobei die Höhe der parallelen Schicht (4, 4') auf der Hauptoberfläche des ersten oder des zweiten Elements zumindest 60 % der Höhe der jeweiligen Lötkugeln auf den Hauptoberflächen ist.

4. Verfahren nach Anspruch 1, wobei die Höhe der parallelen Schicht (4, 4') auf der Hauptoberfläche des ersten oder des zweiten Elements zumindest 70 % der Höhe der jeweiligen Lötkugeln auf den Hauptoberflächen ist.

5. Verfahren nach Anspruch 1, wobei die Höhe der parallelen Schicht (4, 4') auf der Hauptoberfläche des ersten oder des zweiten Elements zumindest 80 % der Höhe der jeweiligen Lötkugeln auf den Hauptoberflächen ist.

6. Verfahren nach Anspruch 1, wobei die Höhe der parallelen Schicht (4, 4') auf der Hauptoberfläche des ersten oder des zweiten Elements zumindest 90 % der Höhe der jeweiligen Lötkugeln auf den Hauptoberflächen ist.

7. Verfahren nach einem der Ansprüche 1 bis 6, wobei die Hauptoberfläche des ersten und/oder des zweiten Elements (1, 1') eine oder mehrere Komponenten oder Strukturen (2) umfassen, die sich von den jeweiligen Hauptoberflächen nach außen erstrecken, wobei die Höhe der einen oder mehreren Komponenten oder Strukturen (2), die auf der Hauptoberfläche vorhanden sind, kleiner als die Höhe der Lötkugel ist, die auf der Hauptoberfläche vorhanden ist, auf der die eine oder mehreren Komponenten oder Strukturen vorhanden sind.

8. Verfahren nach Anspruch 7, wobei eine Schicht aus nicht-leitfähigem Material (4, 4') auf eine der Hauptoberflächen aufgetragen wird, auf der eine oder mehrere Komponenten oder Strukturen (2) vorhanden sind.

9. Verfahren nach Anspruch 8, wobei die Höhe der Schicht (4, 4') größer als die maximale Höhe der Komponenten oder Strukturen (2) ist.

10. Verfahren nach Anspruch 1, wobei die Hauptoberfläche, die den Ausschlussbereich (25) umfasst, des weiteren eine Begrenzungsstruktur (6) umfasst, die eine Umschließung für den Ausschlussbereich bereitstellt.

11. Verfahren nach einem der Ansprüche 1 bis 10, das des weiteren einen Schritt des Durchführens eines Unterfüllungs-/Umspritzungsvorgangs umfasst, der die restlichen Lücken zwischen den Elementen auffüllt.

12. Verfahren zum Herstellen von Stapelstrukturen, wobei das Verfahren nach einem der Ansprüche 1 bis 11 eine ganzzahlige Anzahl von Malen durchgeführt wird, indem eine Hauptoberfläche eines Elements, wie zuvor mit einem Verfahren nach einem der Ansprüche 1 bis 11 gebondet, wiederholt an eine Hauptoberfläche eines weiteren Elements gebondet wird.

13. Verfahren nach Anspruch 12, wobei ein Schritt des Durchführens eines Unterfüllungs-/Umspritzungsvorgangs für die gesamte Stapelstruktur nur einmal durchgeführt wird.

14. Verfahren nach Anspruch 12, wobei der gleiche Lötreflowschritt zum Bonden aller Elemente in einer Stapelstruktur durchgeführt wird.

15. Verfahren nach einem der Ansprüche 1 bis 14, wobei die Elemente Substrate, Chips oder Matrizen sind.

16. Verfahren nach einem der vorstehenden Ansprüche, wobei die Lötkugeln (53, 54) auf beiden der Hauptoberflächen lateral in eine Schicht (52) aus nicht-leitfähigem Material eingebettet werden, wodurch erste und zweite eingebettete Lötkugeln gebildet werden, und das des weiteren den Schritt des Auftragens eines dritten Lötvolumens (55) auf eine der eingebetteten ersten oder zweiten Lötkugeln vor dem Schritt des Bondens umfasst.

17. Verfahren nach Anspruch 16, wobei das dritte Lötvolumen in Form einer dritten Lötkugel (55) angewandt wird.

18. Verfahren nach einem der vorstehenden Ansprüche, wobei die erste und die zweite Lötkugel (3, 3'), oder die erste und die zweite Lötkugel und das dritte Lötvolumen (53, 54, 55) aus dem gleichen Material hergestellt sind.

19. Vorrichtung, die zumindest zwei Elemente (1, 1') umfasst, wobei die Elemente durch eine Bondstruktur gebondet sind, die sich zwischen einer Hauptoberfläche eines ersten Elements (1) und einer Hauptoberfläche eines zweiten Elements (1') befindet, wobei die Bondstruktur eine Lötstruktur (7) umfasst, die im Wesentlichen ein Stapel aus einer unteren und einer oberen Lötkugel ist, die im Wesentlichen eine einzelne Struktur bilden, wobei
- die untere und/oder die obere Lötkugel lateral in eine Schicht (4, 4') aus nicht-leitfähigem Material eingebettet sind und
**dadurch gekennzeichnet, dass**:
die Schicht (4, 4') aus nicht-leitfähigem Material parallel zur jeweiligen Hauptoberfläche verläuft, auf die sie aufgetragen ist, und auf einer der Hauptoberflächen die Schicht (4, 4') aus nicht-leitfähigem Material mit einem Ausschlussbereich (25) versehen ist, bei dem es sich um einen Bereich handelt, wobei kein nicht-leitfähiges Material in dem Bereich vorhanden ist, oder wobei in dem Bereich eine nicht-leitfähige Schicht mit einer geringeren Dicke als auf dem Rest der Hauptoberfläche vorhanden ist, auf der die nicht-leitfähige Schicht (4, 4') aufgetragen ist, und auf der anderen Hauptoberfläche zumindest eine Komponente (30, 31) vorhanden ist, deren Höhe größer als die Höhe der Lötkugel auf der anderen Oberfläche ist, und wobei die Komponente dem Ausschlussbereich zugewandt ist, wenn die Elemente aneinander gebondet sind, so dass die Komponente das gegenüberliegende Element aufgrund des Ausschlussbereichs nicht berührt.

20. Vorrichtung nach Anspruch 19, wobei die Höhe der Schicht (4, 4') aus nicht-leitfähigem Material zumindest 50 % der Höhe der Lötkugel ist, die von der Schicht eingebettet ist.

21. Vorrichtung nach Anspruch 19, wobei die Hauptoberfläche, die den Ausschlussbereich (25) umfasst, des weiteren eine Begrenzungsstruktur (6) umfasst, die eine Umschließung für den Ausschlussbereich bereitstellt.

22. Vorrichtung nach einem der Ansprüche 19 bis 21, wobei die Bondstruktur des weiteren eine Schicht (5) aus Unterfüllungs-/Umspritzungsmaterial zwischen den Hauptoberflächen der Elemente umfasst.

23. Vorrichtung nach Anspruch 22, wobei die Schicht (5) aus Unterfüllungs-/Umspritzungsmaterial zwischen einer Hauptoberfläche eines Elements und einer Einbettungsschicht oder zwischen zwei Einbettungsschichten angeordnet ist.

## Revendications

1. Procédé de collage d'éléments (1, 1') qui comprend les étapes qui consistent à
- produire sur une surface principale d'un premier élément une première bille de soudure (3),
- produire sur une surface principale d'un second élément une deuxième bille de soudure (3'),
- prévoir un contact entre ladite première bille de soudure (3) et ladite deuxième bille de soudure (3'),
- coller ledit premier élément (1) et ledit second élément (1') en appliquant une étape de refusion par laquelle lesdites billes de soudure fondent et forment une structure de billes de soudure jointes (7) dans lequel :
- avant l'étape de collage, la première et/ou la deuxième bille de soudure (3) est intégrée latéralement dans une couche (4, 4') de matériau non conducteur, en prévoyant ladite couche de matériau non conducteur sur la surface principale du premier et/ou second élément, de sorte que la partie supérieure de ladite première et/ou deuxième bille de soudure ne soit pas recouverte par ledit matériau non conducteur, et
- ladite couche (4, 4') de matériau non conducteur intègre latéralement ladite première et/ou deuxième bille de soudure (3) jusqu'à un niveau parallèle à la surface principale sur laquelle la couche non conductrice (4, 4') est prévue,
**caractérisé en ce que** :
sur l'une des dites surfaces principales, la couche (4, 4') de matériau non conducteur est munie d'une zone d'exclusion (25), zone dans laquelle aucun matériau non conducteur n'est présent, ou dans laquelle une couche non conductrice est présente avec une épaisseur inférieure au reste de la surface principale sur laquelle ladite couche non conductrice (4, 4') est appliquée, et sur l'autre surface principale, au moins un composant (30, 31, 40) est présent, et sa hauteur est supérieure à celle de la bille de soudure située sur ladite autre surface, et dans laquelle ledit composant fait face à ladite zone d'exclusion (25) lorsque les éléments sont collés ensemble, de sorte que, en raison de la zone d'exclusion, ledit composant ne touche pas l'élément opposé.

2. Procédé selon la revendication 1, dans lequel la hauteur de ladite couche parallèle (4, 4') sur la surface principale dudit premier ou second élément représente au moins 50 % de la hauteur des billes de soudure respectives sur lesdites surfaces principales.

3. Procédé selon la revendication 1, dans lequel la hauteur de ladite couche parallèle (4, 4') sur la surface principale dudit premier ou second élément, représente au moins 60 % de la hauteur des billes de soudure respectives sur lesdites surfaces principales.

4. Procédé selon la revendication 1, dans lequel la hauteur de ladite couche parallèle (4, 4') sur la surface principale dudit premier ou second élément représente au moins 70 % de la hauteur des billes de soudure respectives sur lesdites surfaces principales.

5. Procédé selon la revendication 1, dans lequel la hauteur de ladite couche parallèle (4, 4') sur la surface principale dudit premier ou second élément représente au moins 80 % de la hauteur des billes de soudure respectives sur lesdites surfaces principales.

6. Procédé selon la revendication 1, dans lequel la hauteur de ladite épaisseur parallèle (4, 4') sur la surface principale dudit premier ou second élément représente au moins 90 % de la hauteur des billes de soudure respectives sur lesdites surfaces principales.

7. Procédé selon l'une quelconque des revendications 1 à 6, dans lequel ladite surface principale du premier et/ou du second élément (1, 1') comprend un(e) ou plusieurs composant(s) ou structure(s) (2) qui s'étendent vers l'extérieur depuis lesdites surfaces principales respectives, la hauteur desdit(e)s composants ou structures (2) présent(e)s sur ladite surface principale étant inférieure à la hauteur de la bille de soudure présente sur ladite surface principale sur laquelle le(s) composant(s) ou la/les structure(s) sont présent(e)s.

8. Procédé selon la revendication 7, dans lequel une couche de matériau non conducteur (4, 4') est appliquée sur l'une desdites surfaces principales sur laquelle un(e) ou plusieurs composants ou structures (2) est/sont présent(e)s.

9. Procédé selon la revendication 8, dans lequel la hauteur de ladite couche (4, 4') est supérieure à la hauteur maximale desdit(e)s composants ou structures (2).

10. Procédé selon la revendication 1, dans lequel la surface principale qui comprend ladite zone d'exclusion (25) comprend en outre une structure de confinement (6), qui offre une enceinte à la zone d'exclusion.

11. Procédé selon n'importe l'une quelconque des revendications 1 à 10, qui comprend en outre une étape d'application d'une opération de remplissage/surmoulage, qui consiste à remplir les espaces restants entre lesdits éléments.

12. Procédé de production de structures superposées, dans lequel le procédé selon l'une quelconque des revendications 1 à 11 est appliqué un nombre entier de fois, en collant répétitivement une surface principale d'un élément, collée auparavant par un procédé selon l'une quelconque des revendications 1 à 11, à une surface principale d'un élément supplémentaire.

13. Procédé selon la revendication 12, dans lequel une étape d'application d'une opération de remplissage/surmoulage est appliquée une seule fois pour toute la structure superposée.

14. Procédé selon la revendication 12, dans lequel la même étape de soudage par refusion est appliquée pour coller tous les éléments en une structure superposée.

15. Procédé selon l'une quelconque des revendications 1 à 14, dans lequel les éléments sont des substrats, des puces ou des matrices.

16. Procédé selon l'une quelconque des revendications précédentes, dans lequel les billes de soudure (53, 54) situées sur lesdites deux surfaces principales sont intégrées latéralement dans une couche (52) de matériau non conducteur, produisant ainsi les première et deuxième billes de soudure intégrées, et qui comprend en outre l'étape d'application d'un troisième volume de soudage (55) sur l'une desdites première ou deuxième billes de soudure intégrées, avant l'étape de collage.

17. Procédé selon la revendication 16, dans lequel ledit troisième volume de soudage est appliqué sous la forme d'une troisième bille de soudure (55).

18. Procédé selon l'une quelconque des revendications précédentes, dans lequel ladite première et ladite deuxième bille de soudure (3, 3'), ou ladite première et ladite deuxième bille de soudure et le troisième volume de soudage (53, 54, 55) sont faits du même matériau.

19. Dispositif qui comprend au moins deux éléments (1, 1'), lesdits éléments étant collés par une structure de collage située entre une surface principale d'un premier élément (1) et une surface principale d'un second élément (1'), ladite structure de collage comprenant une structure de soudure (7) qui est essentiellement une superposition d'une bille de soudure inférieure et d'une bille de soudure supérieure, qui forment une seule structure, dans lequel
- ladite/lesdites bille(s) de soudage inférieure ou/et supérieure est/sont intégrée(s) latéralement dans une couche (4, 4') de matériau non conducteur,
et
**caractérisé en ce que** :
ladite couche (4, 4') de matériau non conducteur est parallèle à la surface principale respective sur laquelle elle est appliquée, et, sur l'une desdites surfaces principales, la couche (4, 4') de matériau non conducteur est munie d'une zone d'exclusion (25), qui est une zone dans laquelle aucun matériau non conducteur n'est présent, ou dans laquelle une couche non conductrice est présente avec une épaisseur inférieure au reste de la surface principale sur laquelle ladite couche non conductrice (4, 4') est appliquée, et, sur l'autre surface principale, au moins un composant (30, 31) est présent, sa hauteur étant supérieure à celle de la bille de soudure située sur ladite autre surface, et ledit composant faisant face à ladite zone d'exclusion lorsque les éléments sont collés ensemble, de sorte que, en raison de la zone d'exclusion, ledit composant ne touche pas l'élément opposé.

20. Dispositif selon la revendication 19, dans lequel la hauteur de ladite couche (4, 4') de matériau non conducteur représente au moins 50 % de la hauteur de la bille de soudure qui est intégrée par ladite couche.

21. Dispositif selon la revendication 19, dans lequel la surface principale qui comprend ladite zone d'exclusion (25) comprend en outre une structure de confinement (6), qui offre une enceinte à la zone d'exclusion.

22. Dispositif selon l'une quelconque des revendications 19 à 21, dans lequel ladite structure de collage comprend en outre une couche (5) de matériau de remplissage/surmoulage entre lesdites surfaces principales desdits éléments.

23. Dispositif selon la revendication 22, dans lequel ladite couche (5) de matériau de remplissage/surmoulage est située entre une surface principale d'un élément et une couche d'intégration, ou entre deux couches d'intégration.
